# EUROPEAN PATENT APPLICATION

(11) **EP 2 061 072 A2**
(43) Date of publication of application: **20.05.2009**
(21) Application number: 08167131.5
(22) Date of filing: 21.10.2008
(51) Int. Cl.: H01L 21/60

(54) **Flip chip wafer, flip chip die and manufacturing processes thereof**

(30) Priority: 15.11.2007 US 940481
(71) Applicant: BIOTRONIK CRM Patent AG, 6341 Baar (CH)
(72) Inventor: Chen, Singjang, Beaverton, OR 97007 (US)
(74) Representative: Lindner-Vogt, Karin L.

(57) **Abstract**

The invention relates to a flip chip wafer comprising an active surface having a plurality of bumps (40, 41, 42) formed thereon and having at least one layer of a cured underfill material (30, 35, 36) accommodated between said plurality of bumps (40, 41, 42). The invention further comprises a flip chip die as well as processes for manufacturing a flip chip wafer and a flip chip die.

## Description

The present invention relates to a flip chip wafer comprising an active surface having a plurality of bumps formed thereon. The invention further relates to a flip chip die and processes for manufacturing the flip chip wafer and the flip chip die.

A flip chip die is a type of semiconductor device which can be mounted without requiring any wire bonds. In the final wafer processing step solder bumps are deposited on the chip pads, which are used to connect directly to the associated external circuitry. This mounting is also known as the Controlled Collapsed Chip Connection or C4.

Flip chip components are predominantly semiconductor devices, however, components such as passive filters, detector arrays, MEMs devices, Integrated Passive Devices, and GMR sensors may be also used in flip chip form.

Flip chip is also called Direct Chip Attach (DCA) since the chip is directly attached to the substrate, board or carrier by the conductive bumps. Nowadays flip chip technology replaces wire bonding which uses face-up chips with a wire connection to each pad.

The boom in flip chip packaging results from flip chip's advantages in size, performance, flexibility, reliability, and cost over other packaging methods. Eliminating packages and bond wires reduces the required board area by up to 95% and requires far less height. Also, flip chip offers high speed electrical performance because eliminating bond wires reduces the delay in inductance and capacitance of the connection. Flip chip technology is well suited for high volume automatic production.

In order to produce a flip chip die the processing is in the beginning similar to conventional IC fabrication with the addition of a few additional steps in the end. The conventional, for instance CSP or BGA integrated circuit structure on a wafer is provided with a plurality of under bump metal pads on its active surface. These under bump metal pads are placed on the chip bond pads by sputtering, plating, or other means to replace the insulating aluminium oxide layer and to define and limit the solder-wetted area. The under bump metallization (UBM) further provides the electrical connection to deeper layers of the integrated circuit. In the next step solder is deposited over the UBM by evaporating, electroplating, screen printing solder paste, or needle-depositing. In order to apply the solder often a lacquer mask with defined openings is used. The result of the solder deposition is a plurality of cylindrical solder bodies as for instance defined by the lacquer mask. In the following step the solder cylinders are melted in order to form small solder bumps (reflow process). Therefore, the flip chip wafer is subjected to a reflow temperature of typically about 320°C. Each of the solder bumps is then typically spherical in configuration and extends from the active surface of the flip chip wafer.

In the next step the flip chip wafer is cut and separated, preferably by sawing, into single IC flip chip dies.

In order to manufacture an assembly with the flip chip die the die is inverted ("flipped") and the solder bumps are bonded with respective bond pads on a carrier substrate. The package structure is again subjected to an elevated temperature (reflow process) and this heat partially melts the solder bumps and bonds them to the carrier substrate. As a result of this step the die is bonded to the carrier substrate but the bonding leaves a small space between the chip's circuitry and the underlying mounting.

In the conventional fabrication of the IC package structure using flip chip technology a so called underfill process follows the bonding of the IC structure. During the underfill process the space between the chip and board is filled with a non-conductive "underfill" adhesive joining the entire surface of the chip to the substrate. The underfill protects the bumps from moisture or other environmental hazards, provides a heat bridge and additional mechanical strength to the assembly. It further compensates for any thermal expansion difference between the chip and the substrate. The underfill mechanically "locks together" chip and substrate so that differences in thermal expansion do not break or damage the electrical connection of the bumps. Conventionally, underfill may be needle-dispensed along the edges of each chip. It is drawn into the under-chip space by capillary action and heat-cured to form a permanent bond to both the chip and the substrate.

As mentioned above underfilling is carried out at the circuit board attachment step. This means that each chip has to be processed individually. Additionally, the underfill material (encapsulant) has to be post-cured subsequently off-line. This known underfilling and post-curing processes become a bottleneck in the high volume manufacturing of flip chip.

The article "Recent advances on waver-level flip chip packaging process", Q. Tong et al., IEEE, 2000 Electronic Components and Technology Conference, page 101, describes a process, where an underfilling encapsulant with built-in flux was precoated on the wafer level. In this process, the underfill was deposited on the entire wafer prior to dicing. At the assembly stage the singulated die is processed as in standard flip chip reflow operations. In this process the precoated underfill with built-in flux cures concurrently with the reflow of the solder allowing both electrical and structural interconnection to be achieved simultaneously. The article describes in detail material development studies of two types of materials which have been prepared, namely thermoplastic and thermoset materials, and which are specifically prepared for screen printing. The materials were also prepared with and without filler to study the impact of filler on rheology. Additionally, the screen printing process with which the underfill encapsulant is applied to the wafer was evaluated in more detail. It was found out that during the screen printing process the process part of the primary deposition method controls the thickness of the film printed with underfill material. Another important factor for underfill reliability seems to be the adhesion. It was demonstrated that by adding selected coupling agents into the underfill encapsulant formulations, and by UV/pre-treatment the adhesion of the underfill material on a variety of substrates can be significantly improved.

As the results of the study discussed in above article show, the described process needs a special formulated underfill material which is more costly than a regular underfill material.

Another disadvantage is that the underfill material may not be fully cured during solder reflow process. Also, material properties (such as thermal expansion coefficient and modulus) were not optimized for the purpose of underfilling. Since a special formulated, new material has to be used this material requires a lot of very costly qualification tests.

Therefore, it is desirable to provide a flip chip die and a flip chip wafer which are less costly in manufacturing and development compared with the above solutions. Additionally, it is desirable to improve the respective manufacturing processes with regard to process time and costs.

According to the present invention a flip chip wafer comprising an active surface having a plurality of bumps thereon is provided. Additionally, the active surface of the flip chip wafer comprises at least one layer of a cured underfill material accommodated between the plurality of bumps. Preferably, the curing is performed at temperatures between approximately 150°C to 170°C and a duration time of approximately 15 min to 2 hours.

The inventive flip chip wafer makes it possible to eliminate the individual underfilling step during an attachment process. This saves a lot of process time and manufacturing costs. Additionally, the curing of the underfill material prior to dicing and attachment with reflow process allows to use underfill material with optimised material properties as used in the known process with individual treatment of each die. No specific underfill material development is necessary.

In one alternative embodiment, the underfill material consists of at least two layers which were applied in the corresponding number of separate steps and were cured separately. Preferablly, underfill material should be single continuous layer.

This flip chip wafer has the advantage that the thickness of all layers of underfill material may be better controlled and different underfill material can be used in different layers. The properties of the underfill material layers can be adapted for instance to the properties of the active surface of the die on the one hand and to properties of the opposite surface of the substrate of the assembly on the other hand onto which the die is attached.

In a further preferred embodiment of the flip chip wafer the underfill material contains epoxy resin, organic acid anhydride or a compound of both. Additional the compound is doped with carbon black pigments, silicon dioxide fillers and other additives - preferably silicon type additives. Preferably this compound has the following composition:

| | Ingredients | Content (wt%) |
|---|---|---|
| Resin | Epoxy resin Organic Acid Anhydride Compound | 35-45 |
| Pigment | Carbon Black | 1 > |
| Filler | Silicon dioxide | 55-65 |
| Additives | Silicon type additives | 5 > |
| | Total | 100 |

Especially the product of NAMIC named CHIPCOAT U8434-6 or the product of ZYMET named CSP-1412 fulfill this composition. These materials have very good properties with regard to curing and application to the flip chip wafer as well as in their function as underfill in the assembly after attachment to a substrate. Their material properties such as yield strength and CTE had been optimized to protect the flip chip and reduce the CTE mismatch between flip chip and circuit board.

In order to form spherical bumps which form excellent bonds after the assembly process the plurality of bumps was subjected to at least one reflow process.

Preferably, curing of the at least one layer of underfill material was performed separately from the reflow process. The advantage of this preferred embodiment is that known underfill materials may be used and the curing process may be better controlled.

According to the present invention an inventive flip chip die is derived from the above described inventive flip chip wafer by cutting and separating the flip chip die from the wafer, preferably by sawing.

Analogous to above mentioned advantages of the inventive flip chip wafer the inventive flip chip die allows to eliminate individual underfilling and curing process steps.

The present invention further comprises a process for manufacturing a flip chip wafer with the following steps:
A1) providing a flip chip wafer with a semiconductor structure and an initial active surface comprising a plurality of under bump metal pads electrically connected to the underlying semiconductor structure,
C1) applying a first layer of underfill material basically to the entire initial active surface of said wafer,
D1) subsequent curing said first layer of underfill material,
E1) applying an etching mask to said cured underfill material in order to provide vias in said first layer of underfill material to said plurality of under bump metal pads,
F1) opening said vias to said plurality of under bump metal pads,
G1) applying solder into said vias leading to one under bump metal pad each,
H1) subjecting said solder to a reflow process forming a plurality of solder bumps.

An alternative inventive process for manufacturing a flip chip wafer with the following steps is provided:
A2) providing a flip chip wafer with a semiconductor structure and an initial active surface comprising a plurality of under bump metal pads electrically connected to the semiconductor structure,
B2) applying solder to the plurality of under bump metal pads and subjecting said solder to a first reflow process in order to form a plurality of first solder bumps on top of said plurality of under bump metal pads,
C2) applying a first layer of underfill material basically to the entire initial active surface of said wafer, which covers said first solder bumps,
D2) subsequent curing said first layer of underfill material,
E2) applying an etching mask to said first layer of underfill material in order to provide vias in said first layer of underfill material to said plurality of first solder bumps,
F2) opening said vias to said plurality of first solder bumps,
G2) applying additional solder into said vias with one of said plurality of first solder bumps each,
H2) subjecting said additional solder and said plurality of first solder bumps to a second reflow process forming a plurality of heightened solder bumps.

In a further embodiment the above mentioned inventive processes may be continued with steps C2) to H2) at least once more with a second layer of underfill material after step H1) or H2) in order to form at least a second layer of cured underfill material accommodated between the plurality of (first) solder bumps or heightened solder bumps on top of the first layer or a subjacent layer of cured underfill material. The advantage of this preferred process is that the height and the material of the underfill can be varied according to the specific application of the flip chip die. Additionally, different underfill material in different layers may be used.

A second alternative inventive process for manufacturing a flip chip wafer with the following steps is provided:
A3) providing a flip chip wafer with a semiconductor structure and an initial active surface comprising a plurality of under bump metal pads electrically connected to the semiconductor structure,
B3) applying solder to the plurality of under bump metal pads and subjecting said solder to a first reflow process in order to form a plurality of first solder bumps on top of said plurality of under bump metal pads,
C3) applying a first layer of underfill material with a predetermined thickness of a fraction of the first solder bumps height, basically to the entire initial active surface of said wafer,
D3) subsequent curing said first layer of underfill material,
G3) applying additional solder to plurality of first solder bumps each,
H3) subjecting said additional solder and said plurality of first solder bumps to a second reflow process forming a plurality of heightened solder bumps,
I3) applying a second layer of underfill material with a predetermined thickness of a fraction of the first solder bumps height, basically to the entire initial active surface of said wafer,
J3) subsequent curing said second layer of said underfill material.

In a further embodiment of the above inventive process, the steps G3), H3), I3) and J3) may be repeated at least once more forming at least a third layer of underfill material. In this process the layers of underfill material may be further varied.

The above mentioned wafer level cured pre-underfill inventive processes offer a lot of potential in terms of reduced production time and increased throughput since these inventive methods eliminate the underfilling and curing process steps for individual modules which saves both time and manufacturing costs. Additionally, since the inventive processes use the well-known underfill material which is used in the individual underfill and curing process the new methods save the time and money necessary for qualifying and developing new underfill material. Further, the above described inventive processes allow to re-work underfilled CSP device with current heat-only rework process. This is because currently underfill material glued the CSP and circuit board together beside the solder bump connect. Normal rework process use heat to re-melt solder and remove the device from circuit board does not work with current flip chip components because underfill material would pickup the solder or some pads and copper trace with it from circuit board. This make the circuit board useless, and the CSP already has underfill materials stick to it cannot be cleaned and re-use. The new invention make the solder bumps taller and underfill materials never come in contact with the circuit board. Therefore, when rework with heat, after solder melted one can just pick up the CSP/with underfill from substrate. The substrate side can be cleaned up by solder wick, and on the CSP side the solder can be re-melted back to spherical shape.

Preferably, the solder used in steps G1), G2) or G3) is applied by plating or screen printing which are well-known and cost-saving methods for application of a solder.

In another preferred embodiment the underfill material contains one or more materials of epoxy resin, organic acid anhydride or a compound of both. Additional the compound is doped with carbon black pigments, silicon dioxide fillers and other additives - preferably silicon type additives. Preferably this compound has the following composition:

| | Ingredients | Content (wt%) |
|---|---|---|
| Resin | Epoxy resin Organic Acid Anhydride Compound | 35-45 |
| Pigment | Carbon Black | 1 > |
| Filler | Silicon dioxide | 55-65 |
| Additives | Silicon type additives | 5 > |
| | Total | 100 |

Especially the product of NAMIC named CHIPCOAT U8434-6 or the product of ZYMET named CSP-1412 fulfill this composition. These materials have very good properties with regard to curing and application to the flip chip wafer as well as in their function as underfill in the assembly after attachment to a substrate.

Finally, the present invention provides a process for manufacturing a flip chip die wherein a flip chip wafer is fabricated according to any of the above mentioned inventive processes and subsequently at least one flip chip die is cut and separated from the flip chip wafer, preferably by sawing.

The inventive process for manufacturing a flip chip die has the same advantages as the above inventive process for manufacturing a flip chip wafer.

A full and enabling disclosure of the present invention, including the best mode thereof, directed to one of ordinary skill in the art, is set forth in the following specification of different embodiments. Thereby, further features and advantages are presented that are part of the present invention independently of the appended claims.

The specification makes reference to the accompanying figures, in which:
- FIG. 1a to 1: c show schematic cross-sections of a flip chip wafer illustrating different steps of a first embodiment of the inventive manufacturing process of a flip chip wafer, wherein FIG. 1c illustrates a schematic cross-section of first embodiment of an inventive flip chip wafer;
- FIG. 2a to 2c: show schematic cross-sections of a flip chip wafer illustrating different steps of a second embodiment of the inventive manufacturing process of a flip chip wafer, wherein FIG. 2c illustrates a schematic cross-section of second embodiment of an inventive flip chip wafer; and
- FIG. 3a to 3c: show schematic cross-sections of a flip chip wafer illustrating different steps of a third embodiment of the inventive manufacturing process of a flip chip wafer, wherein FIG. 3c illustrates a schematic cross-section of third embodiment of an inventive flip chip wafer.

The structure 10 is provided with under bump metal pads 20 which are connected to underneath IC circuits through vias by conductor traces, both vias and traces are buried in dielectric material that insulate the different layers of conductors.

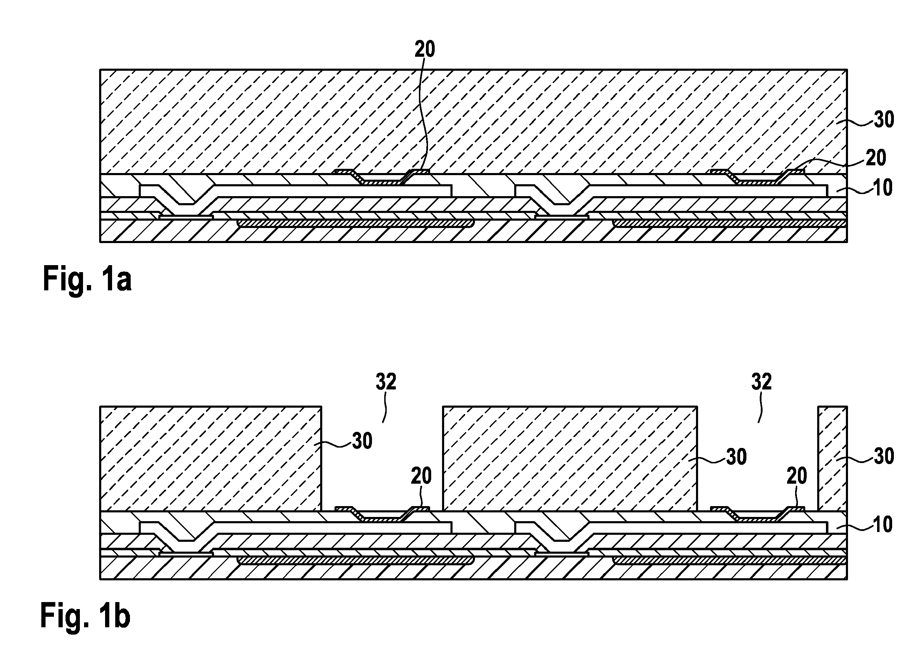

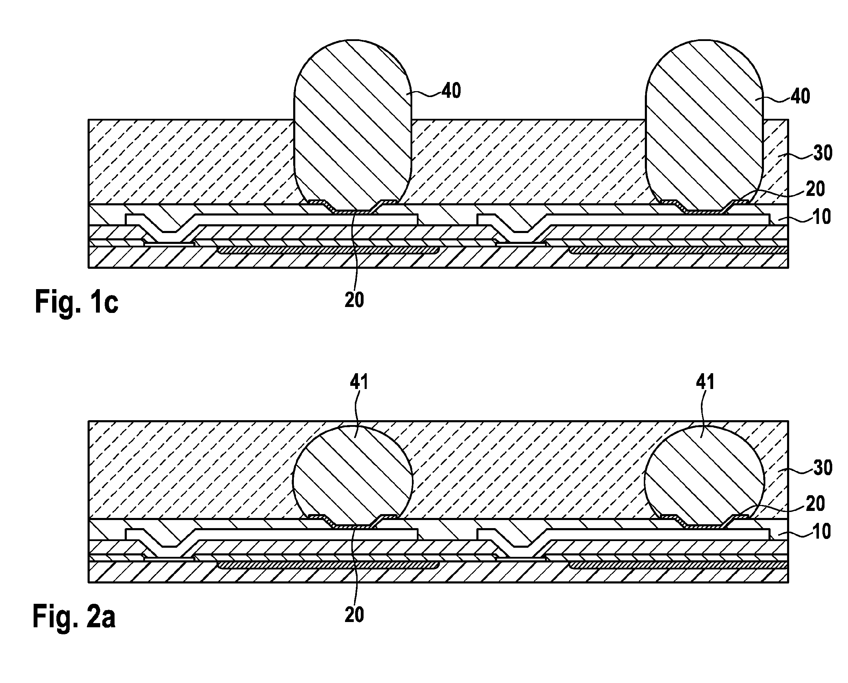

Then, in the first embodiment an underfill material 30 is applied to the entire wafer by needle dispensing. The underfill material is subsequently cured at a temperature of 150°C to 170°C and a curing time of 15 min to 1 hour so that the cross section shown in FIG. 1a is obtained. After that, an etching mask is applied and the vias 32 to find the under bump metal pads are opened (see FIG. 1b) using an Excimer laser (parameters: power density, duration time) or a plasma etching process (parameters: plasma energy, chemical reaction, and duration time). Then, solder is added by a plating or screen printing process followed up by a solder reflow process in order to form solder bumps 40 in the vias 32. The typical peak temperature of the reflow process is 225°C with around 30 s dwell time above solder melting temperature of 183°C. The structure of the resulting wafer with an active surface formed by cured underfill material 30 and solder bumps 40 is illustrated in FIG. 1c. The wafer can then be sawn and separated into individual dies and each die can be attached by a flip chip process to a substrate forming a flip chip assembly.

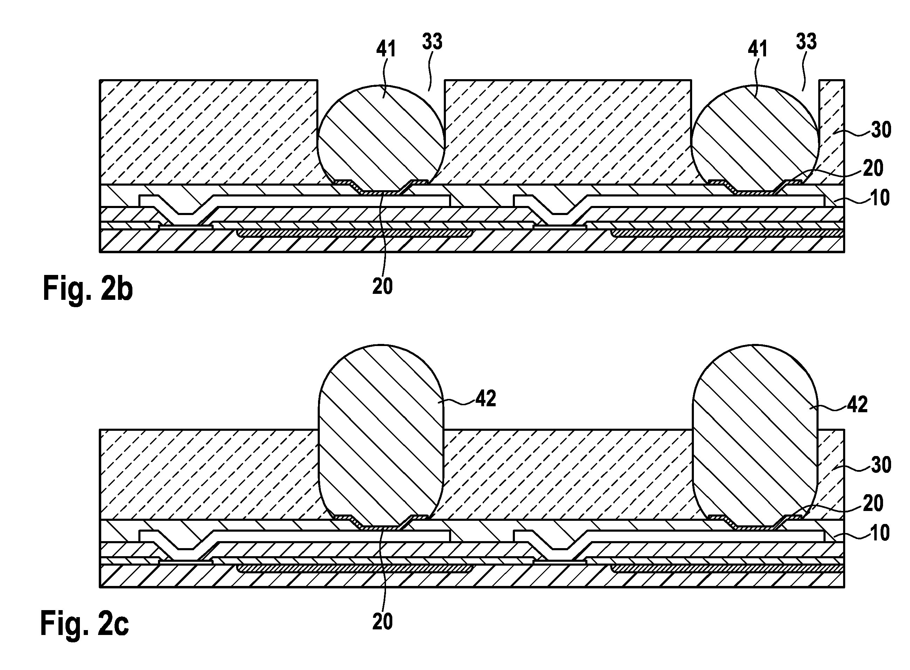

In the second embodiment underfill material 30 is applied by needle after an initial solder bump process step covering the first or initial solder bumps 41 and subsequently cured (curing temperature 150°C to 170°C, curing time 15 min to 1 hour) (see FIG. 2a). After that, an etching mask is applied and the vias 33 to find the solder bumps are opened by Excimer laser or an plasma etching process. The according structure is shown in FIG. 2b. Then, more solder is added into the vias 33 by a plating or screen printing processes followed by an additional reflow process with a typical peak temperature of 225°C with around 30 s dwell time above solder melting temperature of 183°C to make the solder bumps taller. The so obtained wafer is depicted in FIG. 2c. The additional solder and the first solder bumps 41 form the heightened solder bumps 42. Analogous to the first embodiment the wafer having an active surface formed by the cured layer of underfill material 30 and heightened solder bumps 42 which is shown in FIG. 2c can be sawn and separated into individual dies which then can be further processed to manufacture flip chip assemblies.

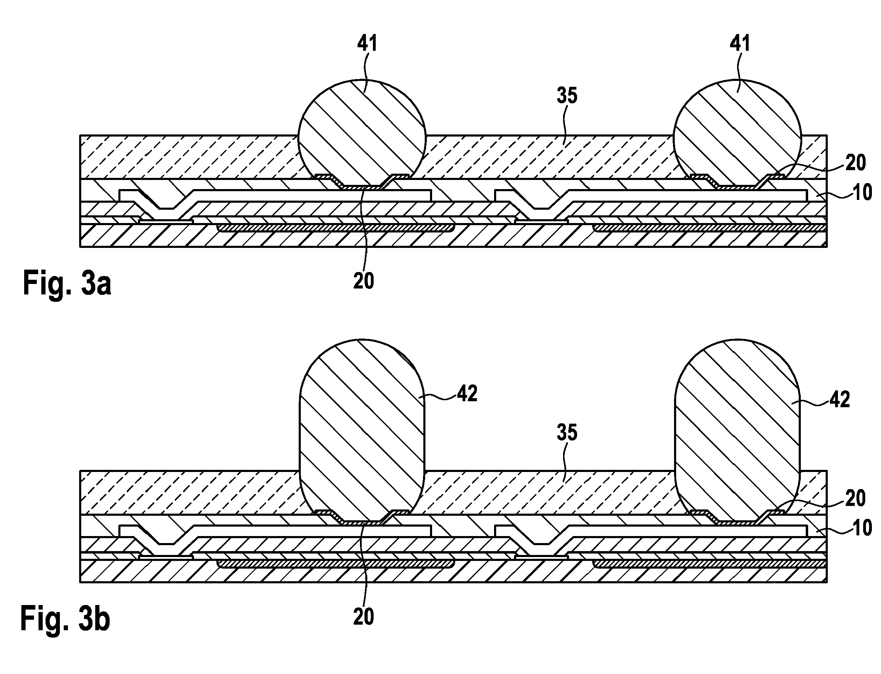

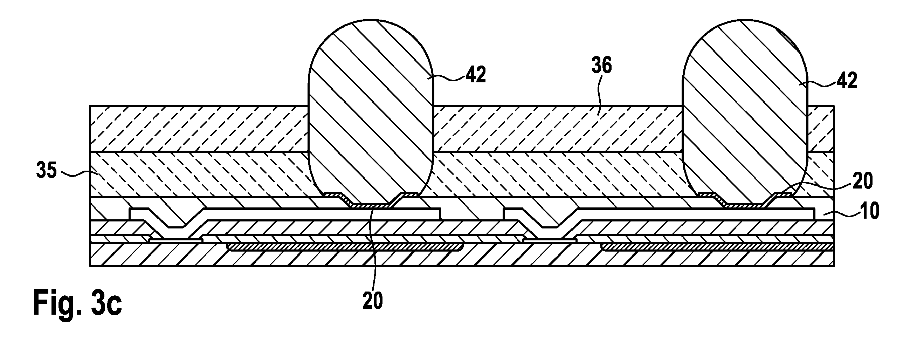

In the first step of the third embodiment of the inventive manufacturing process illustrated in figures 3a to 3c a first layer of underfill material 35 with the thickness one half of the first solder bump 41 height is applied after the initial solder bump process step and is subsequently cured (see FIG. 3a, curing temperature is 150°C to 170°C, curing time is 15 min to 1 hour). After that, more solder is added by plating or screen printing process in order to make the solder bumps taller so that the structure shown in FIG. 3b is obtained. The first solder bumps 41 and the additional solder form the heightened solder bumps 42 after another reflow process (typical peak temperature 225°C with around 30 s dwell time above solder melting temperature of 183°C. In the next step, a second layer of underfill material 36 (preferably the same material, but it could be different material) is applied by needle dispensing again with a thickness of one half of the first solder bump height and is subsequently cured (see FIG. 3c). The resulting wafer structure with an active surface formed by the heightened solder bumps 42 and two super-imposed layers of underfill material 35, 36 wherein the first layer of underfill material 35 is subjacent to the second layer 36 may then analogous to the first and second embodiments be further processed into individual dies and flip chip assemblies.

In another embodiment the thickness of the first layer of underfill material 35 and the second layer of the underfill material 36 may be varied for instance to one 2/5 of the solder bump height for the first layer 35 and 3/5 of the solder bump height for the second layer of underfill material 36. Also, any other height variation of the layers of underfill material 35, 36 is possible.

### List of Reference Numbers

- 10: semiconductor and conductor structure
- 20: under bump metal pad
- 30: layer of underfill material
- 32, 33: via in layer of underfill material 30
- 35: first layer of underfill material
- 36: second layer of underfill material
- 40: solder bump
- 41: first solder bump
- 42: heightened solder bump

## Claims

1. A flip chip wafer comprising an active surface having a plurality of bumps (40, 41, 42) formed thereon and having at least one layer of a cured underfill material (30, 35, 36) accommodated between said plurality of bumps (40, 41, 42).

2. The flip chip wafer according to claim 1, **characterized in that** said underfill material consists of at least two layers (35, 36) which were applied in the corresponding number of separate steps and were cured separately.

3. The flip chip wafer according to any of the preceding claims, **characterized in that** said underfill material (30, 35, 36) contains one or more materials of the group comprising Namic U8434-6, and Zymet CSP-1412.

4. The flip chip wafer according to any of the preceding claims, **characterized in that** said plurality of bumps (40, 41, 42) was subj ected to at least one reflow process.

5. The flip chip wafer according to any of the preceding claims, **characterized in that** curing of said at least one layer of underfill material was performed separately from said reflow process.

6. A flip chip die derived from the flip chip wafer according to any of the preceding claims by cutting and separating the flip chip die from said wafer, preferably by sawing.

7. A process for manufacturing a flip chip wafer with the following steps:
A1) providing a flip chip wafer with a semiconductor structure and an initial active surface comprising a plurality of under bump metal pads (20) electrically connected to the semiconductor structure,
C1) applying a first layer of underfill material (30) basically to the entire initial active surface of said wafer,
D1) subsequent curing said first layer of underfill material (30),
E1) applying an etching mask to said cured first layer of underfill material (30) in order to provide vias (32) in the first layer of underfill material (30) to said plurality of under bump metal pads (20),
F1) opening said vias (32) to said plurality of under bump metal pads (20),
G1) applying solder into said vias (32) leading to one under bump metal pad (20) each,
H1) subjecting said solder to a reflow process forming a plurality of solder bumps (40).

8. A process for manufacturing a flip chip wafer with the following steps:
A2) providing a flip chip wafer with a semiconductor structure and an initial active surface comprising a plurality of under bump metal pads (20) electrically connected to the semiconductor structure,
B2) applying solder to said plurality of under bump metal pads (20) and subjecting said solder to a first reflow process in order to form a plurality of first solder bumps (41) on top of said plurality of under bump metal pads (20),
C2) applying a first layer of underfill material (30, 35) basically to the entire initial active surface of said wafer, which covers said first solder bumps,
D2) subsequent curing said first layer of underfill material (30, 35),
E2) applying an etching mask to said first layer of underfill material (30, 35) in order to provide vias (33) in said first layer of underfill (30, 35) material to said plurality of first solder bumps (41),
F2) opening said vias (33) to said plurality of first solder bumps (41),
G2) applying additional solder into said vias (33) leading to one of said plurality of first solder bumps each (41),
H2) subjecting said additional solder and said plurality of fist solder bumps (41) to a second reflow process forming a plurality of heightened solder bumps (42).

9. The process according to claim 7 or 8, **characterized in that** steps C2) to H2) are repeated at least once more with a second layer of underfill material (36) after step H1) or H2) in order to form at least one second layer of cured underfill material (36) accommodated between said plurality of (first) solder bumps (40, 41) or heightened solder bumps (42) on top of said first layer or a subjacent layer of cured underfill material (35).

10. A process for manufacturing a flip chip wafer with the following steps:
A3) providing a flip chip wafer with a semiconductor structure and an initial active surface comprising a plurality of under bump metal pads electrically connected to the semiconductor structure,
B3) applying solder to the plurality of under bump metal pads and subjecting said solder to a first reflow process in order to form a plurality of first solder bumps on top of said plurality of under bump metal pads,
C3) applying a first layer of underfill material with a predetermined thickness of a fraction of the first solder bumps height, basically to the entire initial active surface of said wafer,
D3) subsequent curing said first layer of underfill material,
G3) applying additional solder to said plurality of first solder bumps each,
H3) subjecting said additional solder and said plurality of first solder bumps to a second reflow process forming a plurality of heightened solder bumps,
I3) applying a second layer of underfill material with a predetermined thickness of a fraction of the first solder bumps height, basically to the entire initial active surface of said wafer,
J3) subsequent curing said second layer of said underfill material.

11. The process according to claim 10, wherein steps G3), H3), I3), and J3) are repeated at least once more forming at least a third layer of underfill material.

12. The process according to any of the claims 7 to 11**, characterized in that** said solder used in step G1), G2) or G3 is applied by plating or screen printing.

13. A process for manufacturing a flip chip die **characterized in that** a flip chip wafer is fabricated according to any of the claims 7 to 12 and subsequently at least one flip chip die is cut and separated from said flip chip wafer, preferably by sawing.
